# EUROPEAN PATENT SPECIFICATION

(11) **EP 4 658 977 B1**
(45) Date of publication and mention of the grant of the patent: **09.12.2026**
(21) Application number: 23702998.8
(22) Date of filing: 31.01.2023
(51) Int. Cl.: G01D 3/02, G01D 3/08, G01D 21/00, G01R 31/00, G05B 23/02, G06F 11/00, G08B 21/18, H03H 21/00

(54) **DETECTING AND CAPTURING EVENT DATA IN A TIME SERIES SENSOR SIGNAL**
DETEKTION UND ERFASSUNG VON EREIGNISDATEN IN EINEM ZEITREIHENSENSORSIGNAL
DÉTECTION ET CAPTURE DE DONNÉES D'ÉVÉNEMENTS DANS UN SIGNAL DE CAPTEUR DE SÉRIE TEMPORELLE

(43) Date of publication of application: 10.12.2025
(73) Proprietor: Eaton Intelligent Power Limited, D04 Y0C2 Dublin 4 (IE)
(72) Inventor: NOWAK, Michael, Milwaukee, Wisconsin 53217 (US); DIMINO, Steven, Wauwatosa, Wisconsin 53213 (US)
(74) Representative: Derry, Paul Stefan
(86) International application number: PCT/EP2023/052254
(87) International publication number: WO 2024/160349

(56) References cited:
- MULLER NILS ET AL: "Assessment of Cyber-Physical Intrusion Detection and Classification for Industrial Control Systems", 2022 IEEE INTERNATIONAL CONFERENCE ON COMMUNICATIONS, CONTROL, AND COMPUTING TECHNOLOGIES FOR SMART GRIDS (SMARTGRIDCOMM), IEEE, 25 October 2022 (2022-10-25), pages 432 - 438, XP034239529, DOI: 10.1109/SMARTGRIDCOMM52983.2022.9961010

## Description

### TECHNICAL FIELD

The invention relates to detecting and capturing events in an input signal that includes time series sensor data. In particular, the invention relates to using a trained classifier to determine whether the input signal includes event data, the determination being based on an error signal between the input signal and a determined prediction of the input signal.

### BACKGROUND

A wide range of applications and technologies are enabled by extracting insights and actionable information from sensor data. For instance, loT (Internet of Things) applications often rely on various aspects of the operation of interconnected components being monitored by various sensors, with the monitored sensor data being stored and/or communicated between the different components. The communicated data from one component may be used by another component to determine appropriate control actions. The collected data may also be used for fault detection and isolation across a network of interconnected components.

In many practical cases, such sensor data is collected with a relatively high sample rate, e.g. to provide fast or real-time response as required by many applications. However, the complexity and costs associated with communicating and storing continuous high sample rate sensor data are significant, and they can present sometimes insurmountable barriers for many practical applications, including at an algorithm development stage.

Muller et al., "Assessment of Cyber-Physical Intrusion Detection and Classification for Industrial Control Systems", 2022 IEEE International Conference On Communications, Control, And Computing Technologies For Smart Grids (SMARTGRIDCOMM), IEEE, 25 October 2022, pages 432-438, DOI: 10.1109/SMARTGRIDCOMM52983.2022.9961010, describe CyPhERS, a Cyber-Physical Event Reasoning System. CyPhERS provides real-time information pertaining the occurrence, location, physical impact, and root cause of potentially critical events in CPSs, without the need for historical event observations. CyPhERS generates informative and interpretable event signatures of known and unknown types of both cyber attacks and physical failures.

It is against this background to which the present invention is set.

### SUMMARY OF THE INVENTION

According to an aspect of the invention there is provided a method of detecting and capturing events in an input signal. The method comprises: (a) receiving the input signal as time series sensor data from one or more sensors; (b) applying a delay to the input signal to obtain a delayed signal; (c) applying a filter to the delayed signal to obtain a predicted signal, the predicted signal being a prediction of the input signal without the applied delay; (d) determining an error signal based on a difference between the predicted signal and the input signal; (e) extracting one or more features from the error signal; and, (f) executing a trained machine learning classifier based on the extracted features to determine whether the input signal includes data indicative of an event. If the input signal is determined to include event data, then the method may comprise initiating capture of the delayed signal for storage.

The input signal may be an electrical signal from one or more electrical sensors.

The electrical signal may be a signal indicative of electrical current from one or more electrical current sensors.

The electrical signal may be a signal indicative of voltage from one or more voltage sensors.

The input signal may be a signal indicative of vibrations from one or more vibration sensors.

The input signal may be an acoustic signal from one or more acoustic sensors.

The input signal may be a temperature signal from one or more temperature sensors.

The delay may be set to be a value greater than a quarter cycle of a defined lowest frequency of interest in the input signal.

The filter may be a digital filter.

The filter may be a finite impulse response filter.

The filter may be an adaptive filter. One or more coefficients of the adaptive filter may be adapted based on the determined error signal.

The one or more coefficients may be adapted according to an iterative adaption algorithm; optionally, wherein the iterative adaption algorithm is a least mean square algorithm.

The trained machine learning classifier may be executed additionally based on one or more of the adapted coefficients of the adaptive filter to determine whether the input signal includes event data.

The adaptive filter may comprise a plurality of different adaptive filters each having a different step size used to adapt one or more coefficients of the respective different adaptive filter. Applying the filter to the delayed signal may comprise applying each of the different adaptive filters to the delayed signal to obtain a plurality of respective different predicted signals. Determining the error signal may comprise determining a plurality of different error signals each based on a difference between the respective different predicted signal and the input signal. Extracting the one or more features from the error signal may comprise extracting one or more features from each of the respective different error signals. Executing the trained machine learning classifier may comprise executing the trained machine learning classifier based on the extracted features from each of the respective different error signals.

One or more of the extracted features may be statistical features of the error signal.

The one or more extracted features may include a root mean square value of the error signal. The one or more extracted features may include a variance of the error signal. The one or more extracted features may include a peak value of the error signal. The one or more extracted features may include a maximum value of the error signal. The one or more extracted features may include a minimum value of the error signal. The one or more extracted features may include a crest factor of the error signal. The one or more extracted features may include a skew of the error signal.

The machine learning classifier may be trained to minimise a false negative classification rate. A false negative is a case in which the input signal includes event data but the machine learning classifier determines that the input signal does not include event data.

The machine learning classifier may be a cost-sensitive classifier to minimise the false negative classification rate.

The machine learning classifier may be a support vector machine classifier.

The captured time series data of the delayed signal may be stored using a circular buffer.

The method may comprise repeating steps (a) to (f) at defined time intervals or substantially continuously, and may comprise continuing to capture time series data of the delayed signal for storage while the input signal is determined to include event data.

If the input signal is determined to not include event data, then the method may comprise halting capture of time series data of the delayed signal for storage.

The method may comprise halting capture of time series data of the delayed signal if the input signal is determined to not include event data for a prescribed time period.

A detected event may be indicative of a fault associated with a component being monitored by the one or more sensors.

According to another aspect of the invention there is provided a non-transitory, computer-readable storage medium storing instructions thereon that, when executed by one or more processors, cause the one or more processors to perform a method as defined above.

According to another aspect of the invention there is provided a controller for detecting and capturing events in an input signal. The controller is configured to receive the input signal as time series sensor data from one or more sensors. The controller is configured to apply a delay to the input signal to obtain a delayed signal. The controller is configured to apply a filter to the delayed signal to obtain a predicted signal, the predicted signal being a prediction of the input signal without the applied delay. The controller may be configured to determine an error signal based on a difference between the predicted signal and the input signal. The controller may be configured to extract one or more features from the error signal. The controller may be configured to execute a trained machine learning classifier based on the extracted features to determine whether the input signal includes data indicative of an event. If the input signal is determined to include event data, then the controller may be configured to initiate capture of the delayed signal for storage.

### BRIEF DESCRIPTION OF THE DRAWINGS

Examples of the invention will now be described with reference to the accompanying drawings, in which:
Figure 1 schematically illustrates a block diagram of processing modules showing how an input signal of obtained sensor data is processed to identify data of interest for storage and/or communication, in accordance with an example of the invention;
Figure 2 shows the steps of a method performed by the processing modules of Figure 1 in accordance with an example of the invention;
Figure 3 schematically illustrates a block diagram of processing modules showing how an input signal of obtained sensor data is processed to identify data of interest for storage and/or communication, in accordance with a different example to that shown in Figure 1; and,
Figure 4 schematically illustrates an arrangement including a power grid, edge devices and a cloud-based system that implements the method of Figure 2 in accordance with an example of the invention.

### DETAILED DESCRIPTION

Power data or high sampling rate sensor data associated with a system, e.g. of interconnected electrical components, can include lots of useful information for performing various applications, e.g. fault detection, such as electrical faults. However, in many applications such sensor data cannot be stored and transmitted continuously for reasons of communication and storage costs.

The present invention is advantageous in that input signals including time series sensor data are analysed to determine whether the input signal includes information of interest, e.g. novel information, data indicative of an event, etc., and then stores and/or communicates the sampled sensor data only if such information of interest is included in the input signal. This recognises that, in many cases, collected sensor data does not include any particularly useful or novel information, e.g. if a component being monitored is operating properly, and that there is therefore no need to store and communication such data.

The present invention provides a machine learning based event detection and waveform capture method and system that determines when novel information, or information otherwise of interest, is contained within a high rate time series signal, and only then saves and/or communicates that information. In this way, the invention significantly reduces the cost and complexity of storing and communicating continuous high rate data which frequently will not include data that is useful for analysis, e.g. fault detection. Further advantages associated with the present invention will become apparent from the following description.

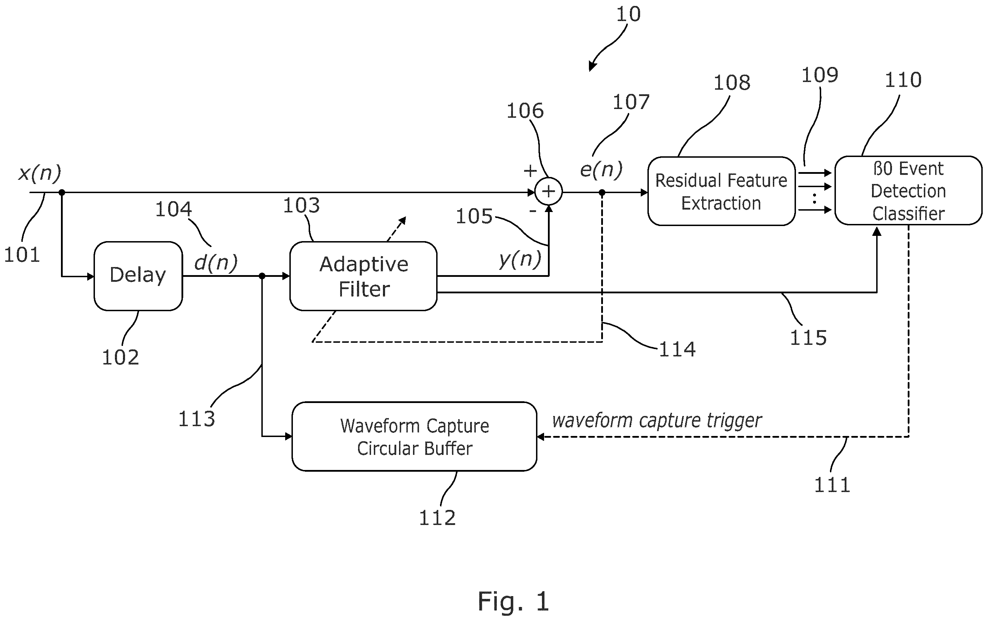

Figure 1 schematically illustrates a block diagram or control system 10 showing how an input signal (x(n)) 101 of interest is processed to identify data of interest for storage and/or communication, in accordance with an example of the invention. The system 10 uses signal filtering to automatically remove predictable information in the input signal 101. In particular, this is performed using a signal delay block / unit 102 and an adaptive filter block / unit 103. The delay and adaptive filter blocks 102, 103 may be referred to collectively as a linear prediction filter (LPF). The delay block 102 generates or determines a delayed version of the signal of interest 101. This delayed signal (d(n)) 104 is provided to the adaptive filter block 103, which generates or determines a predicted signal (y(n)) 105. The predicted signal is a prediction of the input signal 101 in the absence of the applied delay function, i.e. a prediction of what the input signal would look like if the delay had not been applied.

The predicted signal 105 is combined with the (actual) input signal 101 at functional block 106 to generate a residual signal or error signal (e(n)) 107. This error signal 107 is processed by a (residual) feature extraction block / unit 108 to extract features of interest from the error signal 107, and these extracted features 109 are provided as input to a (event detection) classifier block / unit 110. The classifier 110 determines whether or not the extracted features indicate that the input signal 101 includes novel information or other information of interest. If it is determined that the input signal 101 does include information of interest, then the classifier block 110 outputs a trigger signal 111 to a waveform capture circular buffer or data / signal capture block / unit 112. Upon receiving the trigger signal 111, the data capture block 112 initiates capture of the delayed signal 104 for storage and/or communication. In particular, the captured signal 113 may be stored in a database or storage medium accessible by the data capture block 112. The captured / stored data may be communicated to a different location for analysis / processing, e.g. to a cloud location. The operation of the control system 10 is described in greater detail below.

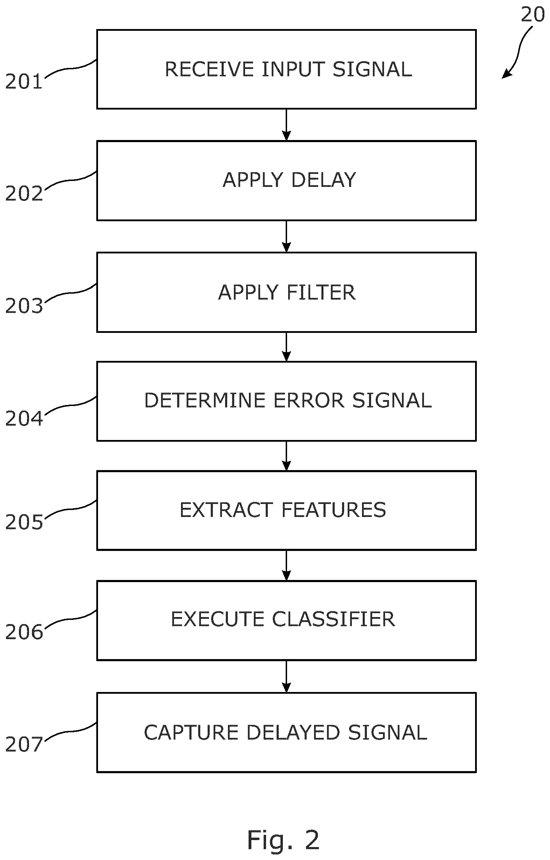

Figure 2 shows steps of a method 20 performed by the control system 10 in accordance with examples of the invention. At step 201, the method involves receiving the input signal 101 as time series sensor data from one or more sensors. The sensor data being received may be any suitable type of sensor data. For instance, the sensor data may be electrical sensor data indicative of one or more parameters of an electrical circuit / component being monitored. This may be electric current data or voltage data, e.g. obtained from a power meter or dedicated sensor. Alternatively, the input signal may include other types of sensor data, such as data indicative of vibrations, acoustics or temperature. The input signal 101 may be received at a relatively high sampling rate. The input signal may be received (substantially) continuously.

At step 202, the method 20 involves applying a delay to the input signal 101 to obtain the delayed signal 104. This is performed by the delay block 102. The delayed signal 104 is a delayed version of the input signal 101. The length of the delay can be set to be any suitable value. It is desired to set the delay value to be high enough such that the filter 103 does actually need to predict how the input signal will look. In one example, the lowest frequency of interest in the input signal 101 may be identified or defined, and the delay value may be set to be a value greater than a quarter cycle of the defined lowest frequency of interest to ensure that the delay is sufficiently high.

At step 203, the method 20 involves applying a filter to the delayed signal 104 to obtain a predicted signal 105. This is performed by the filter block 103. The predicted signal is a prediction of what the input signal would look like in the absence of the applied delay, i.e. without the applied delay. That is, the filter predicts the real-time (non-delayed) version of the same signal. In the described example, the filter is a digital finite impulse response (FIR) filter.

At step 204, the method 20 involves determining the residual or error signal 107 based on a difference between the predicted signal 105 and the input signal 101. The predicted signal 105 may be regarded as being the part of the input signal 101 that is predictable. For instance, electrical signals are periodic in nature, and the filter 103 may be able to predict the periodic component in such an input signal 101. An electrical input signal may also include non-periodic components which the filter cannot predict. The error signal 107 may therefore be regarded as the unpredictable part of the input signal 101, i.e. the part of the signal that remains after the predictable part has been cancelled out by the predicted signal 105. In the case of an electrical input signal, but also other types of signal such as vibrational or acoustic input signals, the error signal 107 may be / include the non-periodic part of the input signal 101. It is the information included in the remaining, unpredictable signal content that is to be used to detect a novel event or event of interest in the input signal, as described below. The periodicity of electrical signals may make the described method particularly suitable for detecting events in electric current and voltage time series signals.

In a 'normally' functioning electrical system / circuit, for instance, the electric current or voltage signal will be in the form of a smooth, sinusoidal signal, i.e. periodic, that is predictable in nature. In such a case, the predicted signal 105 will substantially cancel out the input signal 101, such that the error signal 107 is zero or relatively small. While in some applications, the unpredictable part of the input signal may be non-periodic parts of the signal, in other applications a step change in an otherwise slowly varying signal may be unpredictable and therefore regarded as an event to be captured, e.g. a step change in temperature. More generally, an input signal including data indicative of an event or information of interest may be regarded as an input signal containing sensor data indicative of something other than 'normal', 'expected' or predictable operation of the component(s) / system(s) being monitored by the sensor(s). In one example, an event could be a fault occurring in the relevant / monitored component or system.

In order that the filter 103 can successfully / accurately predict the periodic - or other predictable - parts of the input signal 101, the error signal 107 may be fed back to the filter 103, as indicated by the feedback signal 114 in Figure 1, and used to update the coefficients of the filter 103. In this way, the filter 103 may be an adaptive filter, where the filter coefficient values are adapted with the aim of minimising the residual or error signal 107. The filter coefficient values may be adapted according to any suitable iterative adaption algorithm, such as a least mean square (LMS) algorithm. The filter coefficients are therefore tuned for accurate prediction of the predictable, e.g. periodic, part of the input signal.

The filter 103 is tuned according to a defined adaption step size µ. The step size governs the rate at which the filter 103 reacts or adapts the filter coefficients in response to a magnitude of the error signal 107. This may be regarded as a sensitivity parameter. In particular, the step size is selected / defined to be sufficiently small to guarantee filter convergence and sufficiently large such that the filter can track slow dynamic characteristics, e.g. very gradual upward trends, that would not be considered as events or information of interest to be captured. The step size may therefore be defined to be a value between defined upper and lower thresholds, which may vary depending on the particular application or system dynamics under consideration.

At step 205, the method 20 involves extracting one or more features from the error signal 107. This is performed by the feature extraction unit 108. The features are selected such that they can quickly and accurately encapsulate the characteristics of the unpredictable components in the input signal 101 that remain in the error signal 107 and are based on the dynamic characteristics of the physical sensor measurement(s). These can include various short time windowed features, such as statistical features over a certain, relatively short, time window. These extracted features can include one or more of a root mean square (RMS) value, a variance, a peak value, a maximum value, a minimum value, a crest factor, and a skew, of the error signal. These features may be extracted / determined for overlapping or discrete time intervals / segments. These features may be extracted / determined substantially continuously or at defined time intervals. The extracted features 109 are provided to the classifier 110.

Referring to Figure 1, as indicated by the signal 115, the (adapted / tuned) coefficients / weights of the filter 103 may also be provided as input parameters to the classifier 110. Although these are indicated as being provided directly to the classifier 110 from the filter 103, it will be understood that if the coefficients are in a form in which suitable parameters / features for input to the classifier 110 need to be extracted / determined therefrom, then the coefficients may instead be provided from the filter 103 to the feature extraction unit 108, with the extracted features then being provided as input to the classifier 110. As these filter coefficients represent the predictable components / part of the input signal 101, then beneficially they provide baseline information on the operating state of the system, meaning that novel or other different information in the signal may be determined more accurately. That is, the inclusion of the filter coefficients / weights from the filter 103 provides information on the periodicity, for instance, that is being removed from the input signal 101 (to obtain the error signal 107). The filter weights therefore are indicative of the sinusoidal signal / part of the input signal 101. In one sense, this may be regarded as capturing the characteristics when there is no event data, i.e. information of interest, in the input signal 101, e.g. before an event occurs.

At step 206, the method 20 involves executing the classifier 110 to determine whether the input signal 101 includes data indicative of an event, i.e. novel information or other information of interest. The classifier 110 takes as input the extracted features 109 from the error signal 107, and optionally the filter coefficients 115. The classifier 110 is a statistical binary classifier, such that the output is a binary classification indicating either: the input signal 101 includes information of interest, i.e. event data; or, the input signal 101 does not include event data.

The classifier 110 is in particular a trained machine learning classifier. The classifier 110 is trained with a set of data - that may include real and/or simulated data - that contains both 'normal' operating conditions and typical or expected ('abnormal') event characteristics. That is, the classifier or model is provided with examples of both of the possible binary outputs of the classifier in order to train the classifier.

Beneficially, the classifier 110 may be trained to provide a zero or near zero false negative rate (type II error). A false negative may be regarded as a case in which the classifier determines that the input signal does not include information of interest, but where in fact the input signal does include information of interest. Although it is desired to reduce the amount data storage and transmission resulting from the high sampling rate sensor data, it is also desired to capture all of the senor data that includes information of interest, i.e. it is desired not to miss any event data in the input signal. Training the classifier to have a substantially zero false negative rate ensures that all of the signals that potentially contain novel, information-rich data will be identified and captured. Biasing the classifier training in this way may result in an increased false positive rate, where a false positive may be regarded as a case in which the classifier determines that the input signal does include information of interest, but where in fact the input signal does not include information of interest. However, this is perfectly acceptable for this particular application and, even with a relatively high false positive rate, the benefits of vastly reduced data storage and communication costs are still achieved as compared to continuously storing and communicating the data.

In order to minimise the false negative classification rate, the machine learning classifier 110 may be a cost-sensitive classifier. Cost-sensitive learning is a particular type of learning in which misclassification costs are taken into account when training a model / classifier. By appropriately weighting the false negative cost or penalty when training the classifier 110, the desired performance characteristics can be obtained. In the described example, the machine learning classifier is a support vector machine classifier; however, it will be understood that different machine learning classifiers / algorithms may be used.

At step 207 of the method 20, depending on the outcome / output of the classifier 110, the trigger signal 111 may be sent to the buffer unit 112 to capture data for storage. In particular, if the classifier 110 determines that the input signal includes event data, i.e. information of interest, then the trigger signal 111 is sent to instruct the buffer unit 112 to capture or collect signal data. On the other hand, if the classifier 110 determines that the input signal does not include information of interest, then the trigger signal 111 is not sent. When the buffer unit 112 receives the trigger signal 111, the buffer unit 112 initiates capture / collection of the delayed signal 104 coming from the delay filtering unit 102. The buffer unit 112 may be a circular buffer unit.

In some examples, in addition to data capture being triggered upon an event being detected, the buffer unit 112 may be configured to periodically capture data even if an event is not detected, perhaps according to a schedule, e.g. every ten minutes. Furthermore, the buffer unit 112 may be capable of manual intervention by an operator to initiate data capture at any given time.

Beneficially, as the linear prediction filter (LPF) - including the delay unit 102 - inherently calculates a delayed version of the signal of interest, the delay unit output (i.e. the delayed signal 104) represents the signal of interest (i.e. the input signal 101) before the actual event occurred, which simplifies the implementation of capturing the waveform of interest before a detected event. The onset of an event typically contains the most valuable / useful information in relation to the event, and so it is important to capture the waveform / sensor data prior to the event starting. The sensor data in the delayed signal 102 captured by the buffer unit 112 may be stored in a suitable data memory or storage device accessible by the buffer unit 112. The described method therefore analyses received (time series) sensor data to understand what is important, and then saves a short duration segment of the sensor data that includes information of importance or interest, e.g. for later use in machine learning approaches to diagnose faults, etc.

Steps 201 to 206 of the method 20 may be performed substantially continuously or at defined time intervals. Once the buffer unit 112 initiates capture of the data in the delayed signal 102, the buffer unit 112 may continue to capture and save said data while steps 201 to 206 are being executed and, in particular, at least until the classifier 110 determines that the detected event is finished, i.e. until it is determined that there is no longer information of interest in the input signal. It may be desired to capture some data before an event starts and some data after the event ends (as well as data relating to the event itself), i.e. it may be desirable to capture a data segment that spans before and after the detected event. As such, the buffer unit 112 may continue to capture data until the classifier 110 indicates an absence of detected events for a certain (defined) duration of time, e.g. several seconds. Only after this defined time period has elapsed may the buffer unit 112 halt capture of the delayed signal 104. The absence of detected events may be communicated by the classifier 110 to the buffer unit 112 simply by the absence of the trigger signal 111, i.e. the trigger signal 111 not being sent. Alternatively, the classifier 110 may send a specific (different) signal to the buffer unit 112 to indicate that an event has passed / finished.

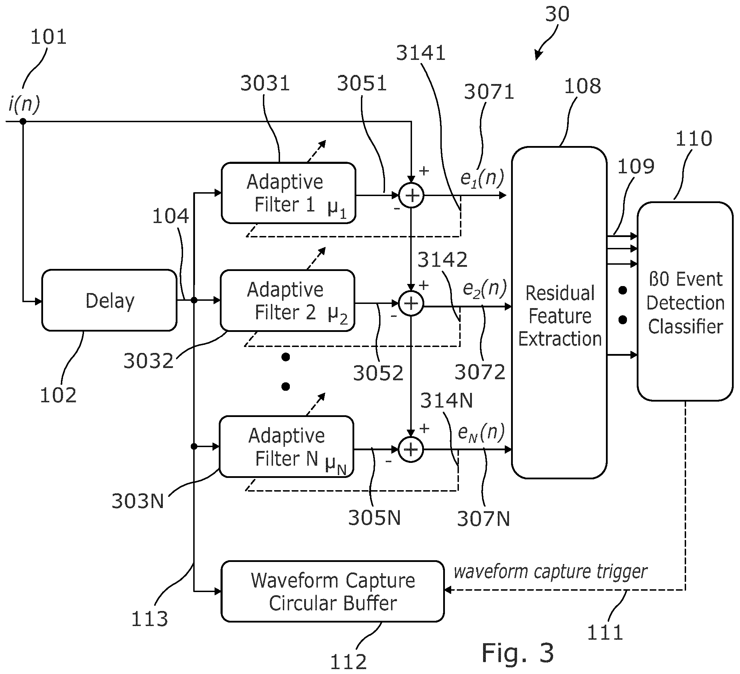

Figure 3 schematically illustrates another example of a block diagram or control system 30 in accordance with the invention. Like the control system 10 in Figure 1, the control system 30 receives an input signal 101 and applies a delay via a delay unit 102 to obtain a delayed signal 104. However, unlike the control system 10 of Figure 1, which includes a single filter unit 103, the control system 30 includes a plurality of adaptive filter units, in particular N filter units 3031, 3032,..., 303N in the illustrated example. Each of the filter units 3031, 3032,..., 303N applies the respective filter to the delayed signal 104 (in series).

Each of the plurality of adaptive filter units 3031, 3032,..., 303N has a different (defined) adaption step size µ₁, µ₂,..., µ_{N}. That is, each of the filters 3031, 3032,..., 303N is adapted according to a different step size parameter for the implemented adaptive filter update algorithm, LMS algorithm. By utilising different step size parameters, each filter 3031, 3032,..., 303N focuses or attempts to cancel different temporal characteristics in the signal of interest. This provides a more flexible approach for applications that are highly dependent on step size. As the step size increases, there is a greater response from the filter. This can be used to track and remove more high frequency content in the input signal.

Each filter 3031, 3032,..., 303N generates a predicted signal 3051, 3052,..., 305N (in a similar manner to Figure 1), and respective residual or error signals 3071, 3072,..., 307N are determined based on a difference between the respective predicted signal 3051, 3052,..., 305N and the input signal 101. The plurality of different error signals 3071, 3072,..., 307N will contain different temporal qualities of the novel event data (information of interest), and this will provide the classifier 110 with a richer / more diverse set of features 309 (extracted by the feature extracted 108), thus enabling more accurate detection of events in the input signal 101. The feedback signals 3141, 3142,..., 314N are used to update the coefficients of the respective filters 3031, 3032,..., 303N. As in Figure 1, the coefficients of the filters 3031, 3032,..., 303N may be provided as input to the classifier 110. As in the control system 101 of Figure 1, in the control system 30 the classifier 110 sends a trigger signal 111 to the circular buffer 112 to initiate capture of the delayed signal 104 if the classifier 110 determines that the input signal 101 includes information of interest.

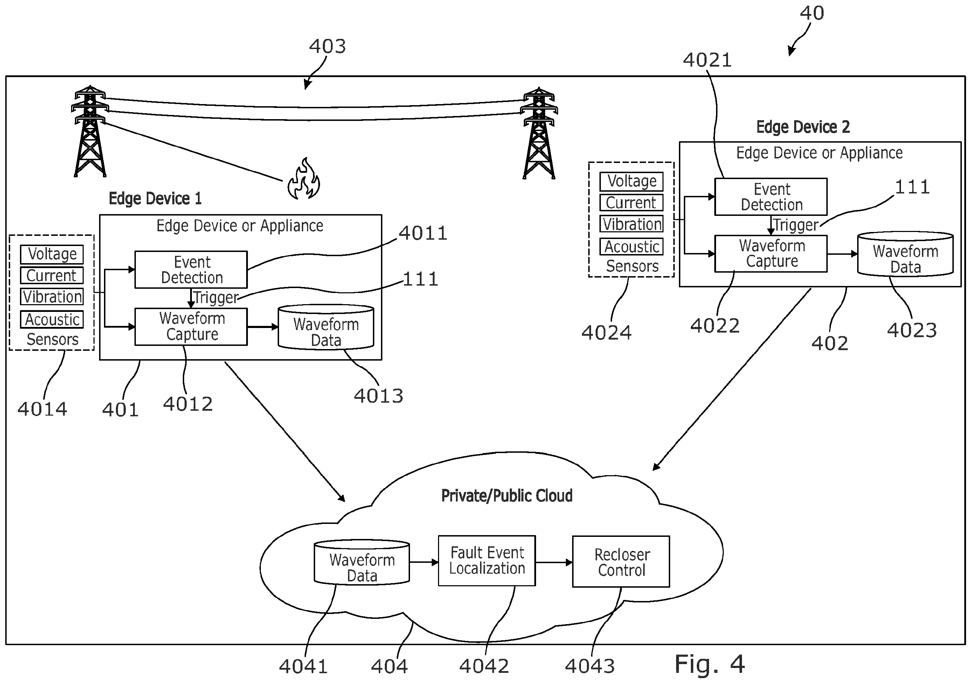

Figure 4 schematically illustrates an example implementation or application of the controller or control system 10, 30 described above. In particular, Figure 4 illustrates an example arrangement 40 in which the method 20 is used to detect and mitigate utility power distribution grid faults. Figure 4 shows a plurality of edge devices 401, 402 (only two are shown, but it will be understood that any suitable number of devices may be included) at geographically different locations within a power grid 403. The edge devices 401, 402 are in wireless communication with public or private cloud-based processing and/or storage system 404.

Each edge device 401, 402 has a controller or computing device implementing an event detection module 4011, 4021 and a waveform / sensor data capture module 4012, 4022. The event detection modules 4011, 4021 may be regarded as having the functionality of the linear prediction filter (LPF) 102, 103, feature extraction unit 108 and classifier 110. The waveform capture modules 4012, 4022 have the functionality of the buffer unit 112, with the trigger signal 111 being sent from the event detection module 4011, 4021 to the waveform capture module 4012, 4022. Data captured by the waveform capture modules 4012, 4022 is stored in respective waveform databases or storage units 4013, 4023. Each edge device 401, 402 receives sensor data from one or more sensors 4014, 4024 for processing as described above to detect whether the sensor data includes event data / information of interest and so should be stored. As mentioned above, the sensors 4014, 4024 can be any suitable type of sensors, e.g. voltage, electric current, vibration, acoustic, temperature, etc.

The cloud-based system 404 includes a waveform database module 4041, a fault event localisation module 4042 and a recloser control module 4043. The sensor data that is captured and stored in the data storage units 4013, 4023 of the edge devices 401, 402 is transmitted to the waveform database module 4041 of the cloud-based system 404. The segments or snapshots of data that are saved in the storage units 4013, 4023 of the edge devices 401, 402 may be time stamped, with this information also being sent to the cloud-based system 404.

When a fault occurs in the grid 403, e.g. a down conductor fault, each edge device 401, 402 will detect, store and transmit the local fault waveform data to the cloud-based system 404. The fault event localisation module 4042 of the system 404 will then aggregate and process the time-stamped event waveform data across a number of the edge devices 401, 402 to determine the precise location of the fault. For instance, this may be determined via temporal or magnitude differences between the waveforms. Once the location of the fault is determined, the recloser control module 4043 can transmit a control signal to actuate or open an optimum set of reclosers of the grid 403 to mitigate potential hazards resulting from the detected fault while maintaining service to the greatest number of customers.

Therefore, information of interest can be detected and stored locally on an edge device or appliance, and/or communicated and stored on a cloud platform for data aggregation across a geographically distributed system. If the same event detection technology is deployed in multiple edge devices across the system, then transient signal dynamics can be captured as they propagate through the system.

It will be understood that Figure 4 illustrates only one of several possible implementations or application of the event detection and capture approach described above.

The described controller of each edge device may be in the form of any suitable computing device, for instance one or more functional units or modules implemented on one or more computer processors. Such functional units may be provided by suitable software running on any suitable computing substrate using conventional or customer processors and memory. The one or more functional units may use a common computing substrate (for example, they may run on the same server) or separate substrates, or one or both may themselves be distributed between multiple computing devices. A computer memory may store instructions for performing the described method performed by the controller, and the processor(s) may execute the stored instructions to perform the method.

Many modifications may be made to the described examples without departing from the scope of the appended claims.

## Claims

1. A method (20) of detecting and capturing events in an input signal, the method comprising:
(a) receiving (201) the input signal (101) as time series sensor data from one or more sensors;
(b) applying (202) a delay (102) to the input signal to obtain a delayed signal (104);
(c) applying (203) a filter to the delayed signal to obtain a predicted signal (105), the predicted signal being a prediction of the input signal without the applied delay;
(d) determining (204) an error signal (107) based on a difference between the predicted signal and the input signal;
(e) extracting (205) one or more features (109) from the error signal;
(f) executing (206) a trained machine learning classifier based on the extracted features to determine whether the input signal includes data indicative of an event; and,
if the input signal is determined to include event data, then the method comprises initiating (207) capture of the delayed signal for storage.

2. A method according to Claim 1, wherein the input signal is an electrical signal from one or more electrical sensors; and optionally,
wherein the electrical signal is:
a signal indicative of electrical current from one or more electrical current sensors;
or,
a signal indicative of voltage from one or more voltage sensors.

3. A method according to any previous claim, wherein the input signal is one of:
a signal indicative of vibrations from one or more vibration sensors;
an acoustic signal from one or more acoustic sensors; and,
a temperature signal from one or more temperature sensors; and/or
wherein the delay is set to be a value greater than a quarter cycle of a defined lowest frequency of interest in the input signal.

4. A method according to any previous claim, wherein the filter is a digital filter and/or a finite impulse response filter.

5. A method according to any previous claim, wherein the filter is an adaptive filter (103), wherein one or more coefficients of the adaptive filter are adapted based on the determined error signal,
optionally wherein the one or more coefficients are adapted according to an iterative adaption algorithm; and further optionally,
wherein the iterative adaption algorithm is a least mean square algorithm.

6. A method according to Claim 5, wherein the trained machine learning classifier is executed additionally based on one or more of the adapted coefficients of the adaptive filter to determine whether the input signal includes event data, and/or
wherein:
the adaptive filter comprises a plurality of different adaptive filters each having a different step size used to adapt one or more coefficients of the respective different adaptive filter;
applying the filter to the delayed signal comprises applying each of the different adaptive filters to the delayed signal to obtain a plurality of respective different predicted signals;
determining the error signal comprises determining a plurality of different error signals each based on a difference between the respective different predicted signal and the input signal;
extracting the one or more features from the error signal comprises extracting one or more features from each of the respective different error signals; and,
executing the trained machine learning classifier comprises executing the trained machine learning classifier based on the extracted features from each of the respective different error signals.

7. A method according to any previous claim, wherein one or more of the extracted features are statistical features of the error signal, and optionally,
wherein the one or more extracted features include one or more of:
a root mean square value of the error signal;
a variance of the error signal;
a peak value of the error signal;
a maximum value of the error signal;
a minimum value of the error signal;
a crest factor of the error signal; and,
a skew of the error signal.

8. A method according to any previous claim, wherein the machine learning classifier is trained to minimise a false negative classification rate, wherein a false negative is a case in which the input signal includes event data but the machine learning classifier determines that the input signal does not include event data, and optionally
wherein the machine learning classifier is a cost-sensitive classifier to minimise the false negative classification rate.

9. A method according to any previous claim, wherein the machine learning classifier is a support vector machine classifier.

10. A method according to any previous claim, wherein the captured time series data of the delayed signal is stored using a circular buffer.

11. A method according to any previous claim, the method comprising repeating steps (a) to (f) at defined time intervals or substantially continuously, and continuing to capture time series data of the delayed signal for storage while the input signal is determined to include event data.

12. A method according to any previous claim, wherein if the input signal is determined to not include event data, then the method comprises halting capture of time series data of the delayed signal for storage, and optionally,
wherein the method comprising halting capture of time series data of the delayed signal if the input signal is determined to not include event data for a prescribed time period.

13. A method according to any previous claim, wherein a detected event is indicative of a fault associated with a component being monitored by the one or more sensors.

14. A non-transitory, computer-readable storage medium storing instructions thereon that, when executed by one or more processors, cause the one or more processors to perform a method according to any previous claim.

15. A controller for detecting and capturing events in an input signal, the controller being configured to perform the method of any one of claims 1-13.

## Patentansprüche

1. Verfahren (20) zur Detektion und Erfassung von Ereignissen in einem Eingangssignal, wobei das Verfahren umfasst:
(a) Empfangen (201) des Eingangssignals (101) als Zeitreihensensordaten aus einem oder mehreren Sensoren;
(b) Anwenden (202) einer Verzögerung (102) auf das Eingangssignal, um ein verzögertes Signal (104) zu erhalten;
(c) Anwenden (203) eines Filters auf das verzögerte Signal, um ein vorhergesagtes Signal (105) zu erhalten, wobei das vorhergesagte Signal eine Vorhersage des Eingangssignals ohne die angewendete Verzögerung ist;
(d) Bestimmen (204) eines Fehlersignals (107) basierend auf einer Differenz zwischen dem vorhergesagten Signal und dem Eingangssignal;
(e) Extrahieren (205) eines oder mehrerer Merkmale (109) aus dem Fehlersignal;
(f) Ausführen (206) eines trainierten Maschinenlernklassifikators basierend auf den extrahierten Merkmalen, um zu bestimmen, ob das Eingangssignal Daten beinhaltet, die indikativ für ein Ereignis sind; und
wenn bestimmt wird, dass das Eingangssignal Ereignisdaten beinhaltet, das Verfahren dann das Initiieren (207) der Erfassung des verzögerten Signals zur Speicherung umfasst.

2. Verfahren gemäß Anspruch 1, wobei das Eingangssignal ein elektrisches Signal aus einem oder mehreren elektrischen Sensoren ist; und optional,
wobei das elektrische Signal Folgendes ist:
ein Signal, das indikativ für einen elektrischen Strom aus einem oder mehreren elektrischen Stromsensoren ist;
oder
ein Signal, das indikativ für die Spannung aus einem oder mehreren Spannungssensoren ist.

3. Verfahren gemäß einem vorhergehenden Anspruch, wobei das Eingangssignal eines von Folgendem ist:
ein Signal, das indikativ für Vibrationen aus einem oder mehreren Vibrationssensoren ist;
ein akustisches Signal aus einem oder mehreren akustischen Sensoren; und
ein Temperatursignal aus einem oder mehreren Temperatursensoren; und/oder
wobei die Verzögerung als ein Wert eingestellt ist, der größer als ein Viertelzyklus einer definierten niedrigsten Frequenz von Interesse in dem Eingangssignal ist.

4. Verfahren gemäß einem vorhergehenden Anspruch, wobei der Filter ein digitaler Filter und/oder ein Filter mit endlicher Impulsantwort ist.

5. Verfahren gemäß einem vorhergehenden Anspruch, wobei der Filter ein adaptiver Filter (103) ist, wobei ein oder mehrere Koeffizienten des adaptiven Filters basierend auf dem bestimmten Fehlersignal angepasst werden,
optional, wobei der eine oder mehrere Koeffizienten gemäß einem iterativen Adaptionsalgorithmus angepasst werden; und ferner optional,
wobei der iterative Adaptionsalgorithmus ein Least-Mean-Square-Algorithmus ist.

6. Verfahren gemäß Anspruch 5, wobei der trainierte Maschinenlernklassifikator zusätzlich basierend auf einem oder mehreren der angepassten Koeffizienten des adaptiven Filters ausgeführt wird, um zu bestimmen, ob das Eingangssignal Ereignisdaten beinhaltet, und/oder
wobei:
der adaptive Filter eine Vielzahl von unterschiedlichen adaptiven Filtern umfasst, wobei jeder eine unterschiedliche Schrittgröße aufweist, die verwendet wird, um einen oder mehrere Koeffizienten des jeweiligen unterschiedlichen adaptiven Filters anzupassen;
das Anwenden des Filters auf das verzögerte Signal das Anwenden jedes der unterschiedlichen adaptiven Filter auf das verzögerte Signal umfasst, um eine Vielzahl von jeweiligen unterschiedlichen vorhergesagten Signalen zu erhalten;
das Bestimmen des Fehlersignals das Bestimmen einer Vielzahl von unterschiedlichen Fehlersignalen, jeweils basierend auf einer Differenz zwischen dem jeweiligen unterschiedlichen vorhergesagten Signal und dem Eingangssignal, umfasst;
das Extrahieren des einen oder mehrerer Merkmale aus dem Fehlersignal das Extrahieren eines oder mehrerer Merkmale aus jedem der jeweiligen unterschiedlichen Fehlersignale umfasst; und
das Ausführen des trainierten Maschinenlernklassifikators das Ausführen des trainierten Maschinenlernklassifikators, basierend auf den extrahierten Merkmalen aus jedem der jeweiligen unterschiedlichen Fehlersignale, umfasst.

7. Verfahren gemäß einem vorhergehenden Anspruch, wobei eines oder mehrere der extrahierten Merkmale statistische Merkmale des Fehlersignals sind, und optional,
wobei das eine oder mehrere extrahierte Merkmale eines oder mehrere von Folgendem beinhalten:
einen quadratischen Mittelwert des Fehlersignals;
eine Varianz des Fehlersignals;
einen Spitzenwert des Fehlersignals;
einen maximalen Wert des Fehlersignals;
einen minimalen Wert des Fehlersignals;
einen Scheitelfaktor des Fehlersignals; und
eine Schräglage des Fehlersignals.

8. Verfahren gemäß einem vorhergehenden Anspruch, wobei der Maschinenlernklassifikator trainiert wird, um eine falsch-negative Klassifikationsrate zu minimieren, wobei ein falsches Negativ ein Fall ist, in dem das Eingangssignal Ereignisdaten beinhaltet, der Maschinenlernklassifikator aber bestimmt, dass das Eingangssignal keine Ereignisdaten beinhaltet, und optional,
wobei der Maschinenlernklassifikator ein kostensensitiver Klassifikator zum Minimieren der falsch-negativen Klassifikationsrate ist.

9. Verfahren gemäß einem vorhergehenden Anspruch, wobei der Maschinenlernklassifikator ein Support-Vektor-Maschinenklassifikator ist.

10. Verfahren gemäß einem vorhergehenden Anspruch, wobei die erfassten Zeitreihendaten des verzögerten Signals unter Verwendung eines zirkulären Puffers gespeichert werden.

11. Verfahren gemäß einem vorhergehenden Anspruch, wobei das Verfahren das Wiederholen von Schritt (a) bis (f) in definierten Zeitintervallen oder im Wesentlichen kontinuierlich und das Fortsetzen der Erfassung von Zeitreihendaten des verzögerten Signals zur Speicherung, während bestimmt wird, dass das Eingangssignal Ereignisdaten beinhaltet, umfasst.

12. Verfahren gemäß einem vorhergehenden Anspruch, wobei, wenn bestimmt wird, dass das Eingangssignal keine Ereignisdaten beinhaltet, das Verfahren dann das Anhalten der Erfassung von Zeitreihendaten des verzögerten Signals zur Speicherung umfasst, und optional,
wobei das Verfahren das Anhalten des Erfassens von Zeitreihendaten des verzögerten Signals umfasst, wenn bestimmt wird, dass das Eingangssignal keine Ereignisdaten für einen vorgegebenen Zeitraum beinhaltet.

13. Verfahren gemäß einem vorhergehenden Anspruch, wobei ein detektiertes Ereignis indikativ für eine Störung ist, die mit einer Komponente assoziiert ist, die von dem einen oder mehreren Sensoren überwacht wird.

14. Nicht-transitorisches, computerlesbares Speichermedium, auf dem Anweisungen gespeichert sind, die, bei Ausführung durch einen oder mehrere Prozessoren, den einen oder mehrere Prozessoren veranlassen, ein Verfahren gemäß einem vorhergehenden Anspruch durchzuführen.

15. Steuergerät zur Detektion und Erfassung von Ereignissen in einem Eingangssignal, wobei das Steuergerät dazu konfiguriert ist, das Verfahren nach einem der Ansprüche 1-13 durchzuführen.

## Revendications

1. Procédé (20) de détection et de capture d'événements dans un signal d'entrée, le procédé comprenant :
(a) la réception (201) du signal d'entrée (101) en tant que données de capteur de série temporelle provenant d'un ou de plusieurs capteurs ;
(b) l'application (202) d'un retard (102) au signal d'entrée pour obtenir un signal retardé (104) ;
(c) l'application (203) d'un filtre au signal retardé pour obtenir un signal prédit (105), le signal prédit étant une prédiction du signal d'entrée sans le retard appliqué ;
(d) la détermination (204) d'un signal d'erreur (107) sur la base d'une différence entre le signal prédit et le signal d'entrée ;
(e) l'extraction (205) d'une ou de plusieurs caractéristiques (109) du signal d'erreur ;
(f) l'exécution (206) d'un classificateur à apprentissage automatique entraîné sur la base des caractéristiques extraites pour déterminer si le signal d'entrée comprend des données indiquant un événement ; et,
si le signal d'entrée est déterminé comme comprenant des données d'événements, alors le procédé comprend l'initiation (207) de la capture du signal retardé pour stockage.

2. Procédé selon la revendication 1, dans lequel le signal d'entrée est un signal électrique provenant d'un ou de plusieurs capteurs électriques ; et éventuellement,
dans lequel le signal électrique est :
un signal indiquant un courant électrique provenant d'un ou de plusieurs capteurs de courant électrique ; ou,
un signal indiquant une tension provenant d'un ou de plusieurs capteurs de tension.

3. Procédé selon une quelconque revendication précédente, dans lequel le signal d'entrée est l'un parmi :
un signal indiquant des vibrations provenant d'un ou de plusieurs capteurs de vibrations ;
un signal acoustique provenant d'un ou de plusieurs capteurs acoustiques ; et,
un signal de température provenant d'un ou de plusieurs capteurs de température ; et/ou
dans lequel le retard est défini pour être une valeur supérieure à un quart de cycle d'une fréquence d'intérêt le plus bas définie dans le signal d'entrée.

4. Procédé selon une quelconque revendication précédente, dans lequel le filtre est un filtre numérique et/ou un filtre à réponse impulsionnelle finie.

5. Procédé selon une quelconque revendication précédente, dans lequel le filtre est un filtre adaptatif (103), dans lequel un ou plusieurs coefficients du filtre adaptatif sont adaptés sur la base du signal d'erreur déterminé,
éventuellement dans lequel les un ou plusieurs coefficients sont adaptés selon un algorithme d'adaptation itératif ; et en outre éventuellement,
dans lequel l'algorithme d'adaptation itératif est un algorithme quadratique moyen.

6. Procédé selon la revendication 5, dans lequel le classificateur à apprentissage automatique entraîné est de plus exécuté sur la base d'un ou de plusieurs des coefficients adaptés du filtre adaptatif pour déterminer si le signal d'entrée comprend des données d'événements, et/ou
dans lequel :
le filtre adaptatif comprend une pluralité de filtres adaptatifs différents présentant chacun une taille de pas différente utilisée pour adapter un ou plusieurs coefficients du filtre adaptatif différent respectif ;
l'application du filtre au signal retardé comprend l'application de chacun des différents filtres adaptatifs au signal retardé pour obtenir une pluralité de signaux prédits différents respectifs ;
la détermination du signal d'erreur comprend la détermination d'une pluralité de signaux d'erreur différents, chacun sur la base d'une différence entre le signal prédit différent respectif et le signal d'entrée ;
l'extraction des une ou plusieurs caractéristiques du signal d'erreur comprend l'extraction d'une ou de plusieurs caractéristiques de chacun des différents signaux d'erreur respectifs ; et,
l'exécution du classificateur à apprentissage automatique entraîné comprend l'exécution du classificateur à apprentissage automatique entraîné sur la base des caractéristiques extraites de chacun des différents signaux d'erreur respectifs.

7. Procédé selon une quelconque revendication précédente, dans lequel une ou plusieurs des caractéristiques extraites sont des caractéristiques statistiques du signal d'erreur, et éventuellement, dans lequel les une ou plusieurs caractéristiques extraites comprennent un ou plusieurs parmi :
une valeur quadratique moyenne du signal d'erreur ;
une variance du signal d'erreur ;
une valeur de crête du signal d'erreur ;
une valeur maximale du signal d'erreur ;
une valeur minimale du signal d'erreur ;
un facteur de crête du signal d'erreur ; et,
un biais du signal d'erreur.

8. Procédé selon une quelconque revendication précédente, dans lequel le classificateur à apprentissage automatique est entraîné pour minimiser un taux de classification en faux négatif, dans lequel un faux négatif est un cas où le signal d'entrée comprend des données d'événements mais le classificateur à apprentissage automatique détermine que le signal d'entrée ne comprend pas de données d'événements, et éventuellement
dans lequel le classificateur à apprentissage automatique est un classificateur sensible aux coûts pour minimiser le taux de classification en faux négatif.

9. Procédé selon une quelconque revendication précédente, dans lequel le classificateur à apprentissage automatique est un classificateur par machine à vecteur de support.

10. Procédé selon une quelconque revendication précédente, dans lequel les données de série temporelle capturées du signal retardé sont stockées à l'aide d'un tampon circulaire.

11. Procédé selon une quelconque revendication précédente, le procédé comprenant la répétition des étapes (a) à (f) à des intervalles temporels définis ou sensiblement en continu, et la poursuite de la capture de données de séries temporelles du signal retardé pour stockage pendant que le signal d'entrée est déterminé comme comprenant des données d'événements.

12. Procédé selon une quelconque revendication précédente, dans lequel si le signal d'entrée est déterminé comme ne comprenant pas de données d'événements, alors le procédé comprend l'arrêt de la capture de données de série temporelle du signal retardé pour stockage, et éventuellement,
dans lequel le procédé comprend l'arrêt de la capture de données de série temporelle du signal retardé si le signal d'entrée est déterminé comme ne comprenant pas de données d'événements pendant une période temporelle prescrite.

13. Procédé selon une quelconque revendication précédente, dans lequel un événement détecté indique une défaillance associée à un composant surveillé par les un ou plusieurs capteurs.

14. Support de stockage non transitoire, lisible par ordinateur, stockant des instructions sur celui-ci qui, lorsqu'elles sont exécutées par un ou plusieurs processeurs, amènent les un ou plusieurs processeurs à réaliser un procédé selon une quelconque revendication précédente.

15. Dispositif de commande pour détecter et capturer des événements dans un signal d'entrée, le dispositif de commande étant configuré pour réaliser le procédé de l'une quelconque des revendications 1 à 13.
